(19) Europäisches Patentamt / European Patent Office / Office européen des brevets

(11) **EP 2 838 122 B1**

(12) **EUROPEAN PATENT SPECIFICATION**

(45) Date of publication and mention of the grant of the patent:
**22.03.2017 Bulletin 2017/12**

(51) Int Cl.:
**H01L 31/042** *(2014.01)*   **C08L 23/04** *(2006.01)*

(21) Application number: **13776091.4**

(86) International application number:
**PCT/KR2013/000863**

(22) Date of filing: **04.02.2013**

(87) International publication number:
**WO 2013/154261 (17.10.2013 Gazette 2013/42)**

(54) **EVA SHEET FOR SOLAR CELL SEALING MATERIAL AND METHOD FOR MANUFACTURING THE SAME**

EVA-FOLIE FÜR EIN SOLARZELLENDICHTUNGSMATERIAL UND VERFAHREN ZUR HERSTELLUNG DAVON

FEUILLE D'ÉTHYLÈNE ACÉTATE DE VINYLE POUR MATÉRIAU D'ENCAPSULATION DE CELLULE SOLAIRE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.04.2012 KR 20120036814**

(43) Date of publication of application:
**18.02.2015 Bulletin 2015/08**

(73) Proprietor: **LG Hausys, Ltd.**
**Seoul 150-721 (KR)**

(72) Inventors:
• **KIM, Chang Il**
**Cheongju-si**
**Chungcheongbuk-do 360-776 (KR)**

• **PARK, Chang Hwan**
**Cheongju-si**
**Chungcheongbuk-do 361-758 (KR)**
• **SEO, Jeong Hyun**
**Busan 607-763 (KR)**

(74) Representative: **Zacco Sweden AB**
**P.O. Box 5581**
**114 85 Stockholm (SE)**

(56) References cited:
**JP-A- 2003 060 218    JP-A- 2009 200 398**
**JP-A- 2011 023 415    JP-A- 2011 097 012**
**JP-A- 2011 249 720**

**Description**

[Technical Field]

The present invention relates to an EVA sheet for solar cell sealants and a method for manufacturing the same. More particularly, the present invention relates to an EVA sheet for solar cell sealants, in which a thermal adhesive layer is formed on an upper side of a backsheet including polyethylene terephthalate (PET), wherein the thermal adhesive layer contains thermal adhesive resin powder including an ethylene resin.

[Background Art]

Recently, instead of power generation relying on typical fossil fuels, solar cells directly converting sunlight, which is a clean energy source, into electric energy are being spotlighted. In particular, when solar cells are used outdoors, for example, on roofs of buildings, the solar cells are generally used in the form of a solar cell module.

Here, most EVA sheets used for solar cells are fabricated by extrusion or calendaring, and a backsheet fabricated by extrusion is subjected to vacuum pressurization, thereby preparing an integrated solar cell module. However, calendering or extrusion used in the preparation of the EVA sheets has a lot of problems during lamination for integration with the backsheet due to shrinkage of the EVA sheets.

To solve such problems, Japanese Patent Publication No. 2002-363507 provides a thermal adhesive sheet exhibiting low thermal shrinkage, and discloses a method of preparing the same, in which thermal adhesive resin powder is sprayed onto a release paper through a spray machine, heated for partial or overall fusion-bonding of the powder, followed by cooling, and then the release paper is peeled off.

In this case, however, production costs of the EVA sheet are increased due to additional cost for peeling of the release paper; the sheet cannot be considered a complete film form before peeling; and the sheet can suffer from deterioration in physical properties such as tension and the like, as compared with EVA sheets manufactured by calendering or extrusion. Moreover, the method provides drawbacks in processes of modularization and lamination for production of an integrated EVA sheet.

[Disclosure]

[Technical Problem]

It is an aspect of the present invention to prepare an EVA sheet including: a backsheet, which includes polyethylene terephthalate (PET); and a thermal adhesive layer formed by depositing thermal adhesive resin powder including an ethylene resin onto an upper side of the backsheet, followed by curing.

[Technical Solution]

In accordance with one aspect of the present invention, an EVA sheet for solar cell sealants includes a thermal adhesive layer formed on an upper side of the backsheet, wherein the thermal adhesive layer contains thermal adhesive resin powder including an ethylene resin.

In accordance with another aspect of the present invention, a method for manufacturing an EVA sheet for solar cell sealants, includes: forming a backsheet by lamination of polyethylene terephthalate (PET); preparing thermal adhesive resin powder including an ethylene resin; spraying the thermal adhesive resin powder onto the backsheet; and forming a thermal adhesive layer by curing the sprayed thermal adhesive resin powder.

[Advantageous Effects]

According to the present invention, since the EVA sheet for solar cell sealants uses a backsheet as a substrate instead of a peelable substrate in the related art and the backsheet is formed by lamination of polyethylene terephthalate (PET), the EVA sheet exhibits no change in properties even at high temperature and exhibits excellent physical properties in terms of fracture strength.

In addition, according to the present invention, since the method for manufacturing an EVA sheet for solar cell sealants simplifies a manufacturing process through integration of the EVA sheet into the backsheet and thus enables the number of components of an existing solar cell module to be reduced to N-1, the method can provide effects including cost reduction, reduction in failure rate of finished products, and the like.

[Description of Drawings]

Figs. 1 and 2 are schematic sectional views of EVA sheets for solar cell sealants according to embodiments of the present invention.
Fig. 3 is a schematic diagram showing a preparation process of an EVA sheet for solar cell sealants according to one embodiment of the present invention.

[Best Mode]

The above and other aspects, features and advantages of the present invention will become apparent from the detailed description of the following embodiments in conjunction with the accompanying drawings. However, it should be understood that the present invention is not limited to the following embodiments and may be embodied in different ways, and that the embodiments are provided for complete disclosure and thorough understanding of the invention by those skilled in the art. The scope of the invention should be defined only by the accompanying claims. Like components will be denoted by like reference numerals throughout the specification.

**EVA sheet for solar cell sealants**

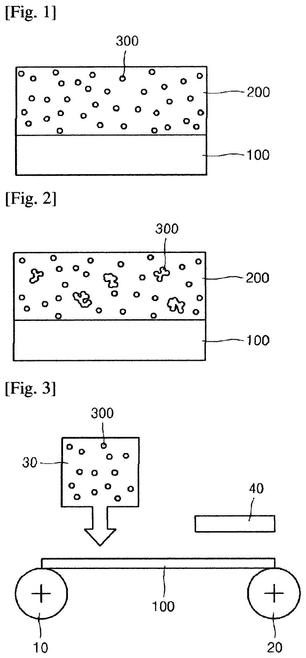

The present invention provides an EVA sheet for solar cell sealants, which includes a thermal adhesive layer formed on an upper side of a backsheet, wherein the thermal adhesive layer contains thermal adhesive resin powder including an ethylene resin.
Referring to Fig. 1, the EVA sheet for solar cell sealants according to the present invention includes a backsheet 100 and a thermal adhesive layer 200, wherein the thermal adhesive layer 200 contains thermal adhesive resin powder 300 including an ethylene resin.
According to the present invention, the backsheet 100 includes polyethylene terephthalate (PET). Although PET is a polymer and exhibits excellent water vapor barrier properties, PET is prone to degradation upon exposure to external environments such as ultraviolet light, infrared light, ozone, and the like. Thus, a PET film composed of PET is subjected to lamination of a fluorine resin and a fluorine-coated film on both surfaces thereof in use.
More specifically, the backsheet according to the present invention may be a TPT having a sandwich structure, in which a polyvinyl fluoride (PVF) film, a polyethylene terephthalate (PET) film and a PVF film are stacked in order. In addition, the PVF film of the TPT may be replaced with a polyvinylidene fluoride (PVDF) film.
In a solar cell module, the backsheet is required to endure high temperature and humidity well and to secure a certain degree of durability for extension of lifespan of the solar cell module, while providing waterproofing, insulation and UV blocking for solar cells. However, since the backsheet is an optional component in typical EVA sheets, the backsheet can be omitted as needed. That is, it is also possible to prepare the solar cell module by forming a glass substrate on upper and lower sides of a solar cell layer without the backsheet.
However, according to the present invention, since the backsheet is an essential component to be integrated with the thermal adhesive layer and modularization of the EVA sheet for solar cell sealants is simplified to reduce the number of components of a typical solar cell module, the EVA sheet for solar cell sealants can allow cost reduction and process simplification.
In addition, typically, a release paper or a peelable paper, which can be peeled off, is used as a substrate independent of the backsheet, and a process for peeling off the release paper or peelable paper is performed, thereby forming a sheet for solar cell sealants, and the like. However, according to the present invention, since the backsheet itself including PET is used as a substrate, the EVA sheet for solar cell sealants, and the like can be obtained simply by a process in which the thermal adhesive resin powder is arranged on the upper side of the backsheet, followed by heating for fusion-bonding.
The thermal adhesive resin powder 300 including an ethylene resin and contained in the thermal adhesive layer 200 refers to resin powder that exhibits adhesion by heating. Specifically, the ethylene resin includes polyethylene, ethylene-vinyl chloride copolymers, ethylene-vinyl acetate copolymers, ethylene-vinyl alcohol copolymers, and the like. The ethylene resin is a copolymer of ethylene and a resin copolymerizable with ethylene.
Examples of the ethylene resin include: copolymers of ethylene and vinyl esters such as vinyl acetate vinyl propionate and the like; copolymers of ethylene and unsaturated carboxylic acid esters such as methyl acrylate, ethyl acrylate, isobutyl acrylate, n-butyl acrylate, methyl methacrylate and the like; copolymers of ethylene and unsaturated carboxylic acids such as acrylic acid, methacrylic acid and the like; copolymers of ethylene, monomers obtained by partially neutralizing unsaturated carboxylic acids with a metal salt such as sodium, zinc, lithium salts and the like, and σ-olefins such as propylene, 1-butene, 1-hexene, 1-octene, 4-methyl-1-pentene and the like; mixtures thereof, and the like.

Preferably, the ethylene resin is an ethylene-vinyl acetate copolymer. Here, properties of the ethylene-vinyl acetate copolymer are determined by the degree of polymerization and the amount of ethylene in the copolymer. With increasing molecular weight of the ethylene-vinyl acetate copolymer, the ethylene-vinyl acetate copolymer exhibits improved properties in terms of toughness, plasticity, stress-cracking resistance and impact resistance, and exhibits deterioration in moldability and surface gloss. If the amount of ethylene in the copolymer is increased, the ethylene-vinyl acetate copolymer has improved properties in terms of density, elasticity, flexibility and compatibility with other polymers or plasticizers, and low softening temperature.

In addition, the ethylene resin may include polyethylene resins, without being limited thereto. The ethylene resin may include homopolymers of ethylene, copolymers in which a vinyl silane compound is grafted to polyethylene, and the like. More specifically, the ethylene resin is a copolymer in which ethylene is present in an amount of 60% by weight (wt%) or more and less than 90 wt%. More preferably, ethylene is present in an amount of 65 wt% to 75 wt%.

Here, the thermal adhesive layer may further include crosslinking agents, crosslinking aids, UV blocking agents and the like, as needed. Discoloration and deformation of the backsheet due to UV light and modularization can be minimized by addition of such additives.

The additives include crosslinking agents, UV blocking agents and the like, and may further include various other additives, as needed. Specifically, examples of the additives may include silane coupling agents, lubricants, antioxidants, flame retardants, anti-discoloration agents, and the like.

In the ethylene resin, if the amount of ethylene in the copolymer is less than 60 wt%, it is difficult to extract the copolymer into powder due to high adhesion of the copolymer. Although the powder is obtained, it becomes difficult to uniformly spray the powder due to deterioration in fluidity of the powder. If it is difficult to uniformly spray the powder, a uniform sheet 4 for sealants cannot be obtained. Here, a non-uniform sheet for sealants means that a resin has a partially different porosity or a sheet has a non-uniform thickness depending upon locations. In addition, due to high adhesion of the copolymer, there is a problem in that the copolymer clings to process machines such as rolls, dies and the like in preparation of the sheet for sealants, thereby causing difficulty in film formation. Further, if the amount of ethylene in the copolymer is greater than 90 wt%, the sheet can suffer from deterioration in transparency and flexibility, and thus is not suitable as an EVA sheet for solar cell sealants.

According to the present invention, the thermal adhesive layer 200 contains the thermal adhesive resin powder 300 including the ethylene resin, in which the thermal adhesive resin powder has a particle size from 30 mesh to 100 mesh. Here, the thermal adhesive resin powder may be obtained by mechanical pulverization, freeze pulverization, chemical pulverization, and the like. If the particle size of the powder is less than 30 mesh, the powder is very fine and can be blown off, or there is difficulty in adjusting the thickness or density of the EVA sheet. If the particle size of the powder is greater than 100 mesh, the powder exhibits poor fluidity and it is difficult to prepare a uniform-thickness EVA sheet.

Referring to Fig. 2, an EVA sheet for solar cell sealants according to another embodiment of the present invention includes a backsheet 100 and a thermal adhesive layer 200, wherein the thermal adhesive layer 200 includes thermal adhesive resin powder 300 including an ethylene resin as a main component, wherein the thermal adhesive resin powder 300 is present in a state in which particles are fused to each other.

Since the thermal adhesive layer 200 is formed through fusion-bonding of particles in the resin powder at a certain melting temperature or less, the thermal adhesive resin powder 300 is partially fusion-bonded and thus can allow the EVA sheet to exhibit better flexibility than existing sheets for sealants. More specifically, since the thermal adhesive resin powder 300 may be partially fusion-bonded, the powder may be present in the form of independent particles, in a state in which a plurality of particles is fusion-bonded to each other, or in a mixed state of particles and fused particles.

The thermal adhesive layer 200 may have a thickness from 0.4 mm to 0.9 mm. If the thickness of the thermal adhesive layer is less than 0.4 mm, there is a concern that workability for desired functions is not realized due to a very thin thickness, and if the thickness of the thermal adhesive layer is greater than 0.9 mm, there is a problem in terms of production costs.

In addition, the backsheet 100 according to the present invention, which is an essential component and includes PET, may have a thickness from 0.05 mm to 5 mm. If the thickness of the backsheet is less than 0.05 mm, there is a risk of tearing the backsheet used as a substrate in preparation of the EVA sheet and if the thickness of the backsheet is greater than 5 mm, there is a problem in that it is difficult to integrate the backsheet with the thermal adhesive layer upon modularization.

Further, the EVA sheet for solar cell sealants according to the present invention, which includes the backsheet 100 and the thermal adhesive layer 200, may have a thickness from 0.25 mm to 0.55 mm after solar cell modularization. Here, if the thickness of the EVA sheet after modularization is less than 0.25 mm, a uniform sheet cannot be obtained, and the sheet can suffer from deterioration in adhesion. In addition, if the thickness of the EVA sheet after modularization is greater than 0.55 mm, there can be a problem in that an adhesive permeates earlier than an adherend due to a very thick adhesive layer upon bonding.

Furthermore, according to the present invention, since an initial thick thickness of the EVA sheet is maintained by spraying of the thermal adhesive resin powder, the EVA sheet including the backsheet, which has no need for a peeling process, and the thermal adhesive layer, can more efficiently prevent solar cell breakage and the like, and can exhibit outstanding thermal shrinkage despite a thinner final thickness thereof after modularization.

According to the present invention, since the EVA sheet for solar cell sealants is manufactured by forming the thermal adhesive layer including the thermal adhesive resin powder on the backsheet including PET, the EVA sheet has a certain level of gel content and thermal shrinkage, and also exhibits physical properties, such as tensile load, tear load and the like, which are suitable for use as an EVA sheet.

In addition, since the backsheet 100 is used as a substrate, an EVA film or the EVA sheet can be manufactured without an additional process such as a peeling process and the like, and can secure physical properties, which can be deteriorated due to peeling of a peelable paper or a release paper. Further, since the backsheet can be omitted from a solar cell module, the overall number of components can be reduced, thereby providing advantages such as reduction in failure rate, and the like.

**Method for manufacturing EVA sheet for solar cell sealants**

The present invention provides a method for manufacturing an EVA sheet for solar cell sealants, which includes forming a backsheet by lamination of polyethylene terephthalate; preparing thermal adhesive resin powder including an ethylene resin; spraying the thermal adhesive resin powder onto the backsheet; and forming a thermal adhesive layer by curing the thermal adhesive resin powder.

According to the present invention, a backsheet 100 may be formed by lamination of polyethylene terephthalate (PET), without being limited thereto. However, since PET is prone to degradation due to exposure to external environments such as ultraviolet light, infrared light, ozone, and the like, the backsheet may be manufactured by laminating a fluorine resin and a fluorine-coated film on both surfaces of the PET film.

In addition, since the backsheet applied to solar cells tends to have a complex multilayer structure, a technique for preparing individual layers such as coating, deposition and the like, and a bonding technique for forming a multilayer of the individual layers may be used. A technique of coating an organic layer onto a film is mainly used along with vacuum deposition in various fields as a basic thin film processing technique.

Among various coating methods, gravure coating, reverse coating or slot die coating is generally used, and a technique of mixing paints and a management technique for a stable coating process should be considered in preparation of the backsheet through coating.

Further, the method for manufacturing an EVA sheet according to the present invention includes preparing thermal adhesive resin powder including an ethylene resin; and spraying the thermal adhesive resin powder onto the backsheet. Here, the thermal adhesive resin powder may be obtained by mechanical pulverization, freeze pulverization, or chemical pulverization of pellets, and the prepared thermal adhesive resin powder is uniformly sprayed onto the backsheet including a polyethylene resin using a powder spraying machine, and the like. Here, since the sprayed thermal adhesive resin powder is cured by heating using a far-infrared heater and the like, the thermal adhesive resin powder is partially fusion-bonded, and the powder particles can be bonded to each other.

More specifically, curing of the thermal adhesive resin powder is performed at a temperature from 70°C to 110°C, preferably from 90°C to 110°C. If the curing temperature is less than 70°C, the thermal adhesive resin powder 300 cannot be sufficiently fusion-bonded. That is, since the EVA sheet exhibits flexibility exceeding suitable flexibility for sheets for solar cell sealants, there can be difficulty in fabrication of a solar cell module. In addition, if the curing temperature is greater than 110°C, the resin powder is fusion-bonded in an amount close to the total amount thereof due to the overly high curing temperature. Thus, there can be problems in that the sheet cannot exhibit flexibility suitable for sheets for sealants, and that the sheet clings to a peelable plate in the preparation thereof.

When the thermal adhesive resin powder 300 is fusion-bonded and the powder particles are bonded to each other by curing and start to form the thermal adhesive layer 200, the overall EVA sheet is cooled. According to the present invention, since the backsheet manufactured first before spraying of the thermal adhesive resin powder is used as a substrate, unlike a typical method including peeling off the manufactured EVA sheet from a release paper or a peelable paper, the method according to the present invention can provide a desired EVA sheet for solar cell sealants without additional peeling and the like.

According to the present invention, the method for manufacturing an EVA sheet for solar cell sealants enables cost reduction as compared with existing processes including a peeling process, and provides outstanding effects in bubble discharge during modularization and in cycle time reduction during the manufacturing process since the EVA sheet includes the thermal adhesive resin powder.

According to the present invention, the method for manufacturing an EVA sheet for solar cell sealants may further include modularization of the manufactured EVA sheet for solar cell sealants. More specifically, modularization may be performed for a vacuum time of 5 minutes or less and for a press time of 10 minutes or less.

As used herein, a vacuum state refers to a state in which the solar cell module is floating in air since pins are elevated from a floor surface at about 150°C, that is, a state in which the solar cell module resides in a high temperature atmosphere while the pins are not in direct contact with the floor surface at about 150°C, and the vacuum time refers to a time for which the vacuum state is maintained. In addition, a press state refers to a state in which the module is in contact with the floor surface at about 150°C and is pressed thereto since the pins are lowered down, and the press time refers to a time for which the module is pressed to the floor surface. Since a vacuum is still maintained during the press time, bubbles can be continuously discharged in the press process.

If the vacuum time is greater than 5 minutes, a long time is spent at high temperature while bubbles partially remain, thereby causing crosslinking due to increase in temperature. However, even if the vacuum time is too short, crosslinking occurs upon pressing while bubbles are not yet discharged, thereby causing the bubbles to remain. Thus, the bubbles can be generated in a certain amount for a suitable period of time, and then removed through pressing. In addition, if the press time is greater than 10 minutes, a solar cell is exposed to high temperature for a long time period and is pressed, whereby the solar cell can crack.

<Example 1>

100 parts by weight of an ethylene-vinyl acetate copolymer, which contained 28 wt% of vinyl oxide and had a melt mass-flow rate of 18 g/10min, was mixed with 1 part by weight of tert-butylperoxy 2-ethylhexyl carbonate, which had a 1-hour half-life temperature of 119.3°C, as a crosslinking agent and 0.5 pats by weight of γ-methacryloxypropyl trimethoxysilane as a silane coupling agent, followed by melting and kneading at a resin temperature of 100°C using an extruder, thereby obtaining a thermal adhesive resin. Next, the thermal adhesive resin was subjected to freeze pulverization using liquid nitrogen, thereby obtaining thermal adhesive resin powder 300 having a particle size of 50 mesh. Next, the thermal adhesive resin powder was uniformly sprayed onto a backsheet 100 using a powder spraying machine, followed by heating to 90°C using a far-infrared heater, thereby performing partial fusion-bonding of the resin powder. As a result, a thermal adhesive layer 200 was formed, thereby providing an EVA sheet for solar cell sealants without a peeling process.

<Example 2>

An EVA sheet for solar cell sealants was fabricated in the same manner as in Example 1 except that the thermal adhesive resin powder 300 had a particle size of 100 mesh and was heated to 100°C using the far-infrared heater, and that the backsheet had a thickness of 0.3 mm.

<Comparative Examples 1 to 3>

An EVA sheet of Comparative Example 1 was an EF2N sheet (SK Co., Ltd.); an EVA sheet of Comparative Example 2 was an EVASKY sheet (Brigestone CO., Ltd.); and an EVA sheet of Comparative Example 3 was a 1628-EVA sheet (Hanwha Co., Ltd.). The EVA sheets of Comparative Examples were manufactured by extrusion and calendering.

<Comparative Example 4>

An EVA sheet for solar cell sealants was fabricated in the same manner as in Example 1 except that a peelable paper composed of PET was used instead of the backsheet, and that removal of the peelable paper was performed after formation of the thermal adhesive layer 200.

**<Experimental Example> Thermal shrinkage of EVA sheet for solar cell sealants**

For each of the sheets for solar cell sealants of Examples and Comparative Examples, a specimen having a size 20 cm×20 cm (width×length) was fabricated, followed by dipping into hot water at 75°C to 80°C for 3 minutes, and then left. Next, the size of each of the specimen was measured before and after dipping, followed by calculation of thermal shrinkage (%).

In addition, to calculate gel content, each of the EVA sheets of Examples and Comparative Examples was subjected to lamination, followed by dipping 1 g of the sheet into toluene at 60°C for 16 hours. Next, the sheet was dried at 110°C for 2 hours, followed by weight measurement, and gel content was calculated according to Equation 1:

$$X \text{ (gel content)} = [1-(Xi-Xs)/Xi] \times 100 \text{ (\%) --- (1)},$$

wherein Xi is an initial weight; Xs is a weight of organic materials remaining on a 300 mesh screen after the sheet was dissolved in toluene, followed by filtration with the 300 mesh screen, and then dried at 110°C for 2 hours; and X is gel content as mentioned in Experimental Example.

Table 1

|  | Modularization temperature (°C) | Modularization time (min) | | Thickness of EVA sheet after modularization (mm) | Gel content (%) | Thermal shrinkage (%) |
|---|---|---|---|---|---|---|
|  |  | Vacuum time | Press time |  |  |  |
| Example 1 | 150 | 3 | 8 | 0.5 | 92 | 0 |
| Example 2 | 160 | 2.5 | 7 | 0.4 | 95 | 0 |
| Comparative Example 1 | 150 | 7 | 13 | 0.7 | 81 | 1 |
| Comparative Example 2 | 160 | 7 | 13 | 0.65 | 85 | 4.6 |
| Comparative Example 3 | 150 | 7 | 13 | 0.7 | 71 | 2.3 |
| Comparative Example 4 | 160 | 6 | 11 | 0.6 | 80 | 2 |

Measurement results of gel content and thermal shrinkage of the EVA sheets of Examples and Comparative Examples are shown in Table 1. From the results, it can be seen that, although the EVA sheets of Examples and Comparative Examples had a similar modularization temperature from 150°C to 160°C, the EVA sheets of Examples had shorter vacuum time and press time than the EVA sheets of Comparative Examples. More specifically, the EVA sheets of Examples 1 and 2 fabricated by sintering fine particles and including the thermal adhesive resin powder had shorter vacuum time and press time at the same modularization temperature than the EVA sheets of Comparative Examples 1 to 3 fabricated by extrusion and calendering, and exhibited excellent gel content and thermal shrinkage despite a thin thickness thereof after modularization.

In addition, although the EVA sheet of Comparative Example 4 included the thermal adhesive layer as in the EVA sheets of Examples 1 and 2, the EVA sheet of Comparative Example 4, which was fabricated using the peelable paper composed of PET and a peeling process, had poorer gel content and thermal shrinkage than the EVA sheets of Examples 1 and 2.

Since the EVA sheets of Examples 1 and 2 had a gel content of 90% or more and a thermal shrinkage of less than 1%, the EVA sheets of Examples 1 and 2 exhibited no shrinkage due to heat upon bonding and thus did not suffer from abnormal phenomena due to thermal shrinkage.

As a result, the EVA sheets for solar cell sealants of Examples 1 and 2, which were fabricated using the backsheet as a substrate and thus employed the backsheet as an essential component before modularization, were fabricated without a peeling process from the substrate, and thus provided outstanding effects in terms of cost reduction and exhibited outstanding gel content and thermal shrinkage. Thus, it could be seen that the EVA sheets of Examples 1 and 2 had improved physical properties as compared with typical EVA sheets.

**Claims**

1.  An EVA sheet for solar cell sealants comprising:

    a thermal adhesive layer (200) formed on an upper side of a backsheet (100),
    wherein the thermal adhesive layer contains thermal adhesive resin powder (300) comprising an ethylene resin,
    the backsheet having a sandwich structure, in which a polyvinyl fluoride (PVF) film, a polyethylene terephthalate (PET) film and a PVF film are stacked in order, or
the backsheet having a sandwich structure, in which a polyvinylidene fluoride (PVDF) film, a polyethylene terephthalate (PET) and a PVDF film are stacked in order.

2. The EVA sheet according to claim 1, wherein the thermal adhesive resin powder is present in a state in which powder particles are fusion-bonded to each other.

3. The EVA sheet according to claim 1, wherein the thermal adhesive layer has a thickness from 0.4 mm to 0.9 mm.

4. The EVA sheet according to claim 1, wherein the backsheet has a thickness from 0.3 mm to 0.5 mm.

5. A method for manufacturing an EVA sheet for solar cell sealants, comprising:

   forming a backsheet (100) by lamination of polyethylene terephthalate;
   preparing thermal adhesive resin powder (300) comprising an ethylene resin;
   spraying the thermal adhesive resin powder onto the backsheet; and
   forming a thermal adhesive layer (200) by curing the sprayed thermal adhesive resin powder.

6. The method according to claim 5, wherein curing of the thermal adhesive resin powder is performed at a temperature from 70°C to 110°C.

7. The method according to claim 5, further comprising: modularization of the EVA sheet for solar cell sealants.

8. The method according to claim 7, wherein modularization of the EVA sheet is performed for a vacuum time of 5 minutes or less and for a press time of 10 minutes or less.


**Patentansprüche**

1. EVA-Folie für Solarzellendichtungsmittel, umfassend:

   einer thermischen Klebeschicht (200), die auf der Oberseite einer Rückseitenfolie (100) ausgebildet ist,
   wobei die thermische Klebeschicht thermisches Klebeharzpulver (300), umfassend ein Ethylenharz, enthält,
   wobei die Rückseitenfolie einen Sandwichaufbau aufweist, in dem eine Polyvinylfluoridfolie (PVF-Folie), eine Polyethylenterephthalatfolie (PET-Folie) und eine PVF-Folie in der Reihenfolge geschichtet sind, oder
   wobei die Rückseitenfolie einen Sandwichaufbau aufweist, in dem eine Polyvinylidenfluoridfolie (PVDF-Folie), eine Polyethylenterephthalatfolie (PET-Folie) und eine PVDF-Folie in der Reihenfolge geschichtet sind.

2. EVA-Folie nach Anspruch 1, wobei das thermische Klebeharzpulver in einem Zustand vorliegt, in dem die Pulverpartikel durch Fusion-Bonding miteinander verbunden sind.

3. EVA-Folie nach Anspruch 1, wobei die thermische Klebeschicht eine Dicke von 0,4 mm bis 0,9 mm aufweist.

4. EVA-Folie nach Anspruch 1, wobei die thermische Klebeschicht eine Dicke von 0,3 mm bis 0,5 mm aufweist.

5. Verfahren zur Herstellung einer EVA-Folie für Solarzellendichtungsmittel, das Folgendes umfasst:

   Ausbilden einer Rückseitenfolie (100) durch Laminieren von Polyethylenterephthalat;
   Zubereiten von thermischem Klebeharzpulver (300), umfassend ein Ethylenharz;
   Aufsprühen des thermischen Klebeharzpulvers auf die Rückseitenfolie; und
   Ausbilden einer thermischen Klebeschicht (200) durch Aushärten des aufgesprühten thermischen Klebeharzpulvers.

6. Verfahren nach Anspruch 5, wobei das Aushärten des thermischen Klebeharzpulvers bei einer Temperatur von 70 °C bis 110 °C erfolgt.

7. Verfahren nach Anspruch 5, das ferner die Modularisierung der EVA-Folie für Solarzellendichtungsmittel umfasst.

**8.** Verfahren nach Anspruch 7, wobei die Modularisierung der EVA-Folie während einer Vakuumzeit von 5 Minuten oder weniger und einer Presszeit von 10 Minuten oder weniger erfolgt.

**Revendications**

**1.** Feuille d'éthylène acétate de vinyle destinée à des produits d'étanchéité de cellule solaire, comprenant :

une couche adhésive thermique (200) formée sur un côté supérieur d'une feuille de support (100),
dans laquelle la couche adhésive thermique contient une poudre de résine adhésive thermique (300) comprenant une résine d'éthylène,
la feuille de support possédant une structure sandwich, dans laquelle un film de fluorure de polyvinyle (PVF), un film de téréphtalate de polyéthylène (PET) et un film de PVF sont empilés dans l'ordre, ou
la feuille de support possédant une structure sandwich, dans laquelle un film de fluorure de polyvinylidène (PVDF), un film de téréphtalate de polyéthylène (PET) et un film de PVDF sont empilés dans l'ordre.

**2.** Feuille d'éthylène acétate de vinyle selon la revendication 1, dans laquelle la poudre de résine adhésive thermique est présente dans un état dans lequel les particules de poudre sont liées par fusion les unes aux autres.

**3.** Feuille d'éthylène acétate de vinyle selon la revendication 1, dans laquelle la couche adhésive thermique a une épaisseur allant de 0,4 mm à 0,9 mm.

**4.** Feuille d'éthylène acétate de vinyle selon la revendication 1, dans laquelle la feuille de support a une épaisseur allant de 0,3 mm à 0,5 mm.

**5.** Procédé de fabrication d'une feuille d'éthylène acétate de vinyle pour produits d'étanchéité de cellule solaire, comprenant :

la formation d'une feuille de support (100) par stratification de téréphtalate de polyéthylène ;
la préparation d'une poudre de résine adhésive thermique (300) comprenant une résine d'éthylène ;
la pulvérisation de la poudre de résine adhésive thermique sur la feuille de support ; et
la formation d'une couche adhésive thermique (200) par durcissement de la poudre de résine adhésive thermique pulvérisée.

**6.** Procédé selon la revendication 5, dans lequel le durcissement de la poudre de résine adhésive thermique est effectué à une température allant de 70 °C à 110 °C.

**7.** Procédé selon la revendication 5, comprenant en outre : la modularisation de la feuille d'éthylène acétate de vinyle pour des produits d'étanchéité de cellule solaire.

**8.** Procédé selon la revendication 7, dans lequel la modularisation de la feuille d'éthylène acétate de vinyle est effectuée pendant un temps de vide de 5 minutes ou moins et pendant un temps de pressage de 10 minutes ou moins.

[Fig. 1]

[Fig. 2]

[Fig. 3]

**EP 2 838 122 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002363507 A